# EUROPÄISCHE PATENTANMELDUNG

(11) **EP 0 948 028 A2**
(43) Veröffentlichungstag der Anmeldung: **06.10.1999**
(21) Anmeldenummer: 99106011.2
(22) Anmeldetag: 25.03.1999
(51) Int. Cl.: H01J 37/22, H01J 37/28

(54) **Verfahren und Anordnung zur räumlichen Visualisierung oberflächendeterminierter Eigenschaften von Mikroobjekten**

(30) Priorität: 31.03.1998 DE 19814205
(71) Anmelder: Kühnert, Rolf Dr. rer. nat., 09126 Chemnitz (DE); Tränkner, Karsten Dipl.-Ing., 09130 Chemnitz (DE)
(72) Erfinder: Kühnert, Rolf Dr. rer. nat., 09126 Chemnitz (DE); Tränkner, Karsten Dipl.-Ing., 09130 Chemnitz (DE)
(74) Vertreter: Körtel, Günther H., Dr.-Ing. Pat.-Ing.

(57) **Zusammenfassung**

Die Erfindung betrifft ein Verfahren zur räumlichen Visualisierung oberflächendeterminierter Eigenschaften von Mikroobjekten, sowie eine Anordnung zur Durchführung eines entsprechenden Verfahrens.

Aufgabe ist, oberflächendeterminierte Eigenschaften von Mikroobjekten mit hohem Auflösungsvermögen und hoher Tiefenschärfe unter Echtzeitbedingungen räumlich unter einem großen Betrachtungswinkelbereich darzustellen.

Erfindungsgemäß erfolgt die Erzeugung von Teilbildern des Mikroobjektes durch rastermikroskopische, vorzugsweise rasterelektronenmikroskopische Abbildung bei variierter elektronenoptischer Kippung des Sonden-Einfallswinkels, und das Mikroobjekt wird räumlich dargestellt auf einem Monitor mit vorgeordneter, mit einer Lichtsteuerungseinrichtung versehenen undurchsichtigen Scheibe, durch welche in Abhängigkeit von sequentiell über der Scheibenfläche verlaufenden lokalen Lichtdurchlässigkeit(en) diesen jeweiligen Positionen zugeordnete, auf dem Monitor wiedergegebene Teilbilder betrachtbar sind, wobei der positionsbezogene Sonden-Einfallswinkel bei der Teilbilderzeugung dem jeweiligen Betrachtungswinkel des auf dem Monitor dargestellten Teilbildes entspricht und der Betrachtungswinkel durch die jeweilige Position der lokalen Lichtdurchlässigkeit der Scheibe in Bezug auf das zugeordnete Teilbild bestimmt ist.

Anwendungsgebiete sind insbesondere die Bereiche der Mikrotechnologien und der Mikrosystemtechnik.

## Beschreibung

Die Erfindung betrifft ein Verfahren zur räumlichen Visualisierung oberflächendeterminierter Eigenschaften von Mikroobjekten, sowie eine Anordnung zur Durchführung eines entsprechenden Verfahrens.

Unter Mikroobjekten werden im folgenden Objekte verstanden, die in wenigstens einer ihrer Abmessungen ganz oder teilweise zu klein sind, um mit bloßem Auge, d. h. ohne optische, elektronische und/oder mechanische Einrichtung hinreichend genau betrachtet werden zu können.

Oberflächendeterminierte Eigenschaften sollen verschiedene oberflächennahe geometrische und/oder physikalische bzw. chemische Eigenschaften des Mikroobjekts beinhalten, wie z. B. geometrisch bedingte lokale Topographieinformationen, Materialverteilungen, strukturelle und/oder chemische Eigenschaffen.

Dementsprechend ist die Erfindung anwendbar in allen den Bereichen, in denen Ergebnisse aus der qualitativen und/oder quantitativen Untersuchung der oberflächendeterminierten Eigenschaften mikroskopisch bemessener Objekte abgeleitet werden. Insbesondere trifft dies auf Anwendungsbereiche der Mikrotechnologien (Mikroelektronik, Mikromechanik, Mikrooptik, Mikrochemie) und der Mikrosystemtechnik zu, wie z. B. die räumliche Darstellung von Strukturen, Aufbauten, Komponenten oder Baugruppen der Mikroelektronik und/oder Mikromechanik im Bearbeitungs-, Kontroll- oder Montageprozeß.

Es ist bekannt, unter Verwendung eines Raster-Elektronenmikroskops stereoskopische Ansichten eines Objekts zu erzeugen. Gemäß US-PS 40 39 829 wird der Einfallswinkel des Elektronenstrahls bezüglich des Objekts abwechselnd auf einen ersten bzw. zweiten festen Wert eingestellt. Die beiden so erhaltenen Bilder des Objekts werden gleichzeitig an verschiedenen Stellen zur Anzeige gebracht. Bei Betrachtung der Bilder z. B. unter einem Stereoskop wird eines der Bilder durch das linke Auge und das zweite Bild durch das rechte Auge des Betrachters betrachtet, so daß ein stereoskopischer Bildeindruck entsteht.

Diese Art der stereoskopischen Bilderzeugung erfordert die wiederholte schnelle Änderung des Einfallswinkels des Elektronenstrahls. Dies erfolgt entweder durch entsprechende Beeinflussung des Elektronenstrahls bei unveränderter Lage des Objektes mit einer entsprechenden Änderung der Elektronenoptik, oder durch eine entsprechende schnelle Lageänderung des Objekts mit den damit verbundenen Nachteilen, wie z. B. Schwingungen, mechanischer Verschleiß.

Nach DE-PS 28 36 699 wird ein Eingriff in die Elektronenoptik wie auch eine Änderung des Einfallswinkels des Elektronenstrahls vermieden, indem das Objekt um einen Winkel geneigt und festgehalten wird und ein Rechner die durch die Neigung der Objekt- zur Bildebene hervorgerufene Verschiebung berechnet und auf dem Bildschirm zur Anzeige bringt.

Vorstehende bekannte Verfahren ermöglichen nicht eine räumliche Visualisierung unter Echtzeitbedingungen, d. h. eine Betrachtung aus beliebigen Betrachtungswinkeln innerhalb eines vorgegebenen Raumwinkelbereichs. Auch ist die räumliche Echtzeit-Visualisierung weiterer oberflächendeterminierter Eigenschaften nicht als bekannt entnehmbar.

Aus DE-PS 42 28 111 sind weiterhin ein Verfahren und eine Vorrichtung zur Erzeugung stereoskopischer Darstellungen bekannt. Dabei erfolgt die Aufnahme unter Verwendung einer CCD-Matrix-Kamera, welche in einem definierten Abstand hinter einer Spezialglasscheibe angeordnet ist. Diese enthält schnell umschaltbare Flüssigkristallelemente, so daß durch entsprechende elektronische Ansteuerung eine oder mehrere kleine durchsichtige Öffnungen in Form eines Streifens sequentiell über die gesamte Scheibenfläche verlaufen. Dadurch werden zweidimensionale Teilbilder unter bestimmten Betrachtungswinkeln aufgenommen, die in entsprechende elektrische Signale gewandelt werden.

Die Wiedergabe dieser Teilbilder erfolgt mit Hilfe eines Spezial-Monitors mit veränderten Zeilenlauf, dem eine entsprechende Spezialglasscheibe im analogen Abstand vorgeordnet ist. Dabei wird der jeweiligen, sich mit hinreichender Geschwindigkeit über die Scheibenfläche bewegenden durchsichtigen Öffnung der Spezialglasscheibe ein entsprechendes Teilbild auf dem Monitor zugeordnet und (unter dem bestimmten Betrachtungswinkel) dargestellt, so daß der Betrachter ein vollständiges stereoskopisches Bild in einem großen Betrachtungswinkelbereich erkennt.

Nachteilig bei diesem Verfahren und der entsprechenden Vorrichtung ist deren Nichtanwendbarkeit auf die räumliche Visualisierung oberflächendeterminieter Eigenschaften von Mikroobjekten.

Der Erfindung liegt die Aufgabe zugrunde, ein Verfahren der eingangs genannten Art sowie eine Anordnung zur Durchführung eines entsprechenden Verfahrens anzugeben, wobei oberflächendeterminierte Eigenschaften von Mikroobjekten mit hohem Auflösungsvermögen und hoher Tiefenschärfe unter Echtzeitbedingungen räumlich unter einem großen Betrachtungswinkelbereich darstellbar sind.

Diese Aufgabe wird erfindungsgemäß mit den in den Ansprüchen 1 und 5 dargelegten Merkmalen gelöst, wobei die weiteren Ansprüche 2 bis 4 und 6 bis 8 vorteilhafte Ausgestaltungen beinhalten.

Die Vorteile der Erfindung bestehen insbesondere in der Möglichkeit, Mikroobjekte mit einem hohen Auflösungsvermögen und mit hoher Tiefenschärfe räumlich innerhalb eines großen Betrachtungswinkelbereich darzustellen, wozu keinerlei mechanische Bewegungselemente erforderlich sind. Die elektronenoptische Kippung des Einfallswinkels der Sonde realisiert die verschiedenen Betrachtungswinkel der erzeugten Teilbilder auf technisch einfache und bequeme Weise. Die elektronenoptische Charakteristik der Bilderzeugung entspricht der 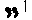 Beleuchtung" der Oberfläche des Mikroobjekts mit parallelem Licht, so daß die optischen Bedingungen für das Funktionsprinzip der eingesetzten stereoskopischen Abbildung in vorteilhafter Weise realisierbar sind. Günstig ist weiterhin die monochromatische Charakteristik der im Rastermikroskop erzeugten Teilbilder. Die Möglichkeit der räumlichen Echtseit-Visualisierung entspricht einer 3-D-Vergrößerung des Mikroobjekts.

Darüber hinaus erlaubt die Erfindung die räumliche Darstellung von über Topographieinformationen hinausgehenden geometrischen, physikalischen und/oder chemischen Eigenschaften von Mikroobjekten in Oberflächennähe.

Die Erfindung wird nachfolgend an einem Ausführungsbeispiel näher erläutert. In der zugehörigen Zeichnung ist eine Anordnung zur Durchführung des erfindungsgemäßen Verfahrens mit einem teilweise schematisch dargestellten, axial geschnittenen Raster-Elektronenmikroskop, einem speziellen Monitor und einer entsprechenden Schaltungsanordnung dargestellt. Anhand deren Arbeitsweise wird anschließend das erfindungsgemäße Verfahren erläutert.

Das Raster-Elektronenmikroskop enthält eine Kathode 1, welche eine Elektronensonde 2 erzeugt. Diese wird durch ein mehrstufiges elektronenoptisches Ablenksystem 3 mit Ablenkspulen, Objektiv und Kondensor beschleunigt, geformt sowie unter Ablenkung gegen die Oberfläche des zu untersuchenden Mikroobjekts 4 fokussiert. Die Ablenkung wird durch ein, von einem in einer Steuer- und Verarbeitungseinheit 5 befindlichen digitalen Ablenkgenerator 6 ausgegebenes Ablenksignal so gesteuert, daß die Elektronensonde 2 punkt- und zeilenweise über den zu untersuchenden Oberflächenausschnitt des Mikroobjekts 4 geführt wird. Unter der Wirkung der Elektronensonde 2 werden im primär angeregten Volumen des Mikroobjekts 4 u. a. Sekundärelektronen 7 ausgelöst, deren Intensität durch einen Sekundärelektronendetektor 8 erfaßt wird. Das Sekundärelektronenintensitätssignal wird über einen Signalverstärker 9 auf einen Analog-Digital-Wandler 10 geführt und die entsprechenden positionsabhängigen Werte positionsbezogen in einzelnen Speicherbereichen einer Grafikkarte 11 gespeichert. Der Ausgang der Grafikkarte 11 ist auf den Intensitätsregler für den Wiedergabeelektronenstrahl eines als Kathodenstrahlröhre ausgebildeten Monitors 12 geführt.

Um eine zur Ablenkung der Elektronensonde 2 synchrone Ablenkung des Wiedergabeelektronenstrahls im Monitor 12 zu erreichen, ist dessen Ablenkeinrichtung 13 mit einer Positionssteuerung 14 verbunden, auf die ebenfalls das vom digitalen Ablenkgenerator 6 erzeugte Ablenksignal geführt ist.

Dem am elektronenoptischen Ablenksystem 3 anliegenden Ablenksignal ist weiterhin ein Steuersignal überlagert, wodurch der Sonden-Einfallswinkel der Elektronensonde 2 bezüglich der Oberfläche des Mikroobjekts 4 variiert wird. Das entsprechende Steuersignal ist vom digitalen Ablenkgenerator 6 auf eine elektronische Ansteuerung einer LCD-Scheibe 15 mit schnell umschaltbaren Flüssigkristallelementen geführt, wobei eine oder mehrere sequentiell über die Fläche der LCD-Scheibe 15 verlaufende durchsichtige Öffnung(en) erzeugbar sind. Die LCD-Scheibe 15 ist in definiertem Abstand vor dem Bildschirm des Monitors 12 angeordnet.

Die Arbeitsweise ist wie folgt:

Durch die rasterelektronenmikroskopische Abrasterung des zu untersuchenden Oberflächenausschnittes des Mikroobjekts 4 werden positionsbezogene zweidimensionale Teilbilder in Bildpunktdarstellung erzeugt, wobei der jeweilige Helligkeitswert der Bildpunkte dem digitalisierten Sekundärelektronenintensitätssignal proportional ist. Vorstehendes geschieht in Abhängigkeit vom jeweiligen positionsbezogenen Einfallswinkel der Elektronensonde 2 bezüglich der Oberfläche des Mikroobjekts 4, d. h. jedes Teilbild ist eine zweidimensionale Projektion des räumlichen Oberflächenausschnittes des Mikroobjekts 4 aus der Perspektive des jeweiligen Sonden-Einfallswinkels.

Diese Teilbilder werden in den Speicherbereichen der Grafikkarte 11 abgelegt, wodurch bildpunktweise die Intensität des Wiedergabeelektronenstrahls des Monitors 12 geregelt wird. Die räumliche Darstellung des zu untersuchenden Oberflächenausschnittes des Mikroobjekts 4 erfolgt auf dem Bildschirm des Monitors 12 mit vorgeordneter LCD-Scheibe 15, indem jeweils entsprechende Teilbilder mit hoher Bildwiederholrate auf dem Monitor 12 hinter einer bestimmten Position von durchsichtigen Öffnungen der LCD-Scheibe 15 erzeugt werden. Dabei erfolgt der Zeilenlauf im Monitor 12 nur im Bereich des Teilbildes. Der positionsbezogene aktuelle Sondeneinfallswinkel der Elektronensonde 2 entspricht bei der jeweiligen Teilbilderzeugung genau und fortlaufend dem jeweiligen Betrachtungswinkel des auf dem Monitor 12 dargestellten Teilbildes, wobei der Betrachtungswinkel durch die jeweilige Position der vorgeordneten durchsichtigen Öffnung der LCD-Scheibe 15 bestimmt ist. D. h. , die einzelnen Teilbilder werden auf dem Monitor 12 infolge der entsprechenden Wirkung der vorgeordneten LCD-Scheibe 15 nur unter solchen Betrachtungswinkeln zur Anzeige gebracht, die den für die Aufzeichnung des jeweils dargestellten Teilbildes benutzten Sondeneinfallswinkels entspricht. Die Betrachtung des jeweiligen Teilbildes ist nur aus einem dem zur Teilbilderzeugung verwendeten Sonden-Einfallswinkels zugehörigen Betrachtungswinkel möglich. Entsprechend kann der Betrachter in einem großen Bereich aufgrund der hohen Geschwindigkeit der Vorgänge und der Trägheit des Auges ein räumliches Bild des zu untersuchenden Oberflächenauschnittes des Mikroobjektes 4 wahrnehmen.

Die Erfindung ist auf vorstehendes Ausführungsbeispiel nicht beschränkt. So ist sie über die räumliche Darstellung von lokalen Topographieinformationen hinausgehend geeignet für die Darstellung von (weiteren) physikalischen und/oder chemischen Eigenschaften des zu untersuchenden Mikroobjekts 4, wobei die Wechselwirkungssignale ausgewählter Signalarten (neben dem im Ausführungsbeispiel beschriebenen Sekundärelektronenintensitäts-Signal z. B. ein Reflexionselektronen-Signal, ein Absorptionselektronen-Signal, ein Auger-Elektronen-Signal, ein Röntgen-Signal) auch gemischt werden können. Damit ist z. B. die Materialverteilung bzw. die Materialzusammensetzung räumlich darstellbar.

Anordnungsgemäß ist statt eines als Kathodenstrahlröhre ausgebildeten Monitors 12 auch das Vorsehen eines LCD-Displays möglich und zweckmäßig.

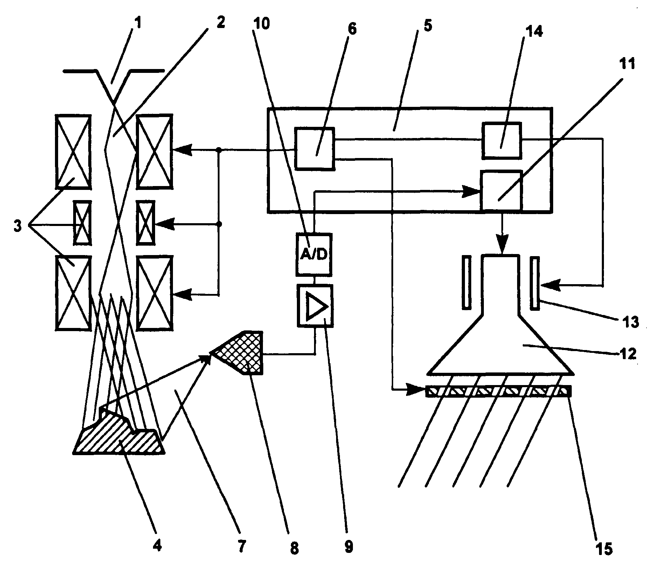

## Patentansprüche

1. Verfahren zur räumlichen Visualisierung oberflächendeterminierter Eigenschaften von Mikroobjekten,
gekennzeichnet durch die folgenden Schritte:
a. Erzeugung von zweidimensionalen Teilbildern des darzustellenden Mikroobjektes (4) durch rastermikroskopische Abbildung, wobei das jeweilige Teilbild bei hoher Bildwiederholrate durch Abrasterung mit einer Sonde (2) und Detektierung der infolge der Wechselwirkung zwischen Sonde (2) und oberflächennahen Objektbereichen ausgelösten Intensität bestimmter Signalarten bei variierter elektronenoptischer Kippung des Einfallswinkels der Sonde (2) bezüglich der Objektoberfläche aufgenommen wird,
b. räumliche Darstellung des Mikroobjekts (4) auf einem Monitor (12) mit vorgeordneter, mit einer Lichtsteuerungseinrichtung versehenen undurchsichtigen Scheibe (15), durch welche in Abhängigkeit einer oder mehrerer sequentiell über der Scheibenfläche verlaufenden lokalen Lichtdurchlässigkeit(en) diesen jeweiligen Positionen zugeordnete, auf dem Monitor (12) wiedergegebene Teilbilder betrachtbar sind,
c. wobei der positionsbezogene aktuelle Einfallswinkel der Sonde (2) bezüglich der Objektoberfläche bei der Teilbilderzeugung genau und fortlaufend dem jeweiligen Betrachtungswinkel des auf dem Monitor (12) dargestellten Teilbildes entspricht und der Betrachtungswinkel durch die jeweilige Position der lokalen Lichtdurchlässigkeit der Scheibe (15) in Bezug auf das zugeordnete Teilbild bestimmt ist.

2. Verfahren nach Anspruch 1, dadurch gekennzeichnet, daß die Erzeugung von Teilbildern unter Verwendung eines Raster-Elektronenmikroskops erfolgt.

3. Verfahren nach Anspruch 1 und 2, dadurch gekennzeichnet, daß die detektierten Wechselwirkungssignale digitalisiert, positionssynchron gespeichert und dem Monitor 12 als Teilbild nur unter den Betrachtungswinkeln zugeführt werden, die dem für die Aufzeichnung des jeweiligen Teilbildes benutzten Einfallswinkels der Sonde (2) entspricht.

4. Verfahren nach Anspruch 1, dadurch gekennzeichnet, daß die detektierten Wechselwirkungssignale ausgewählter Signalarten zwecks Abbildung verschiedener oberflächennaher geometrischer und/oder physikalischer Eigenschaften des Mikroobjektes (4) verwendet und/oder gemischt werden.

5. Anordnung zur Durchführung eines Verfahrens zur räumlichen Visualisierung oberflächendeterminierter Eigenschaften von Mikroobjekten, dadurch gekennzeichnet, daß das am Sekundärelektronendetektor (8) eines Raster-Elektronenmikroskops anliegende Sekundärelektronenintensitätssignal über einen Signalverstärker (9) und einen Analog-Digital-Wandler (10) als jeweiliges Teilbild positionsbezogen auf einzelne Speicherbereiche einer Grafikkarte (11) geführt ist, wodurch die lokale Intensität der Bildwiedergabe eines Monitors (12) gesteuert wird, wobei ein im Ablenkgenerator (6) des Raster-Elektronenmikroskops erzeugtes Ablenksignal auf das elektronenoptische Ablenksystem (3) des Raster-Elektronenmikroskops zwecks Abrasterung des Mikroobjektes (4) und synchron auf die Positionssteuerung (14) des Monitors (12) geführt ist, so daß aufgenommene Teilbilder wiedergegeben werden,
und ein den Sonden-Einfallswinkel variierendes Steuersignal für das elektronenoptische Ablenksystem (3) auch eine dem Monitor (12) vorgeordnete, mit einer Lichtsteuereinrichtung versehene undurchsichtige Scheibe (15) so ansteuert, daß sequentiell über die Scheibenfläche verlaufende lokale Lichtdurchlässigkeiten den auf dem Monitor (12) wiedergegeben Teilbildern zugeordnet sind.

6. Anordnung nach Anspruch 5, dadurch gekennzeichnet, daß der Monitor (12) einen veränderten Zeilenlauf in den Grenzen jedes Teilbildes besitzt.

7. Anordnung nach Anspruch 5 und 6, dadurch gekennzeichnet, daß der Monitor (12) als Kathodenstrahlröhre oder als LCD-Display ausgeführt ist.

8. Anordnung nach Anspruch 5 und 7, dadurch gekennzeichnet, daß die mit einer Lichtsteuereinrichtung versehene undurchsichtige Scheibe (15) eine LCD-Scheibe ist.
